(19) Europäisches Patentamt
European Patent Office
Office européen des brevets

(11) **EP 1 979 930 B1**

(12) **EUROPÄISCHE PATENTSCHRIFT**

(45) Veröffentlichungstag und Bekanntmachung des Hinweises auf die Patenterteilung:
**19.08.2015 Patentblatt 2015/34**

(21) Anmeldenummer: **06817733.6**

(22) Anmeldetag: **04.12.2006**

(51) Int Cl.:
*H01L 21/67* (2006.01)    *H01L 21/00* (2006.01)
*C23C 14/02* (2006.01)

(86) Internationale Anmeldenummer:
**PCT/CH2006/000681**

(87) Internationale Veröffentlichungsnummer:
**WO 2007/082396 (26.07.2007 Gazette 2007/30)**

(54) **VORRICHTUNG ZUR ENTGASUNG EINES SCHEIBENFÖRMIGEN SUBSTRATES**

APPARATUS FOR DEGASSING A WAFER-LIKE SUBSTRATE

DISPOSITIF DE DÉGAZAGE D UN SUBSTRAT EN FORME DE DISQUE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **18.01.2006 CH 70062006**

(43) Veröffentlichungstag der Anmeldung:
**15.10.2008 Patentblatt 2008/42**

(73) Patentinhaber: **Oerlikon Advanced Technologies AG**
**9496 Balzers (LI)**

(72) Erfinder: **SCHOLTE VAN MAST, Bart**
**CH-9478 Azmoos (CH)**

(74) Vertreter: **Troesch Scheidegger Werner AG**
**Schwäntenmos 14**
**8126 Zumikon (CH)**

(56) Entgegenhaltungen:
**US-A1- 2002 116 836    US-B1- 6 263 587**

**Beschreibung**

Die Erfindung bezieht sich auf eine Vorrichtung zur Entgasung eines scheibenförmigen Substrates gemäss Anspruch 1 sowie auf ein Verfahren zur Entgasung eines scheibenförmigen Substrates gemäss Anspruch 15. Ähnlicher Gegenstand wird in US-B-6,263,587 offenbart.

Bei modernen Vakuumprozessanlagen werden kreisrunde flache Substrate bzw. Werkstücke, die auch als Wafer bezeichnet werden, in solchen vollautomatisierten Vakuumprozesssystemen oberflächenbehandelt, wie beispielsweise beschichtet, geätzt, gereinigt, thermisch behandelt etc. Um derartige Prozesse zu automatisieren und um mehrstufige Prozesse in verschiedenen Anlagenbereichen durchführen zu können, werden hierbei automatisierte Transportsysteme, eine Art Handling-Roboter, eingesetzt. Insbesondere die Behandlung von Halbleiter-Wafern erfodert bei derartigen Prozessen eine sehr hohe Qualität der Behandlung, wie insbesondere hohe Reinheit, hohe Präzision und sorgfältiges Behandeln der Substrate. Wegen den erwähnt hohen Anforderungen weisen derartige Anlagen bevorzugt eine Schleusenkammer auf, wo die Wafer von atmosphärischer Umgebung in einen Vakuumraum verbracht werden und danach in eine Prozessstation oder in der Regel nacheinander in mehrere Prozessstationen, um die geforderte Oberflächenbearbeitung vornehmen zu können. Die Wafer werden hierbei mit Hilfe einer Transporteinrichtung bevorzugt in einer horizontalen Transportebene von der Schleusenkammer in die Prozesskammer gebracht, wobei nach Ablegen des Wafers in der Prozesskammer diese in der Regel abgeschlossen wird, um dort den Prozess unter den geforderten Vakuumprozessbedingungen durchführen zu können. Auf dieselbe Art und Weise wird wenn mehrere Prozessschritte benötigt werden, der Wafer wieder aus der reinen Prozesskammer heraus transportiert und für den nächsten Prozessschritt in eine andere Prozesskammer transportiert. Besonders bevorzugte Anlagentypen sind hierbei sogenannte Cluster-Systeme. Bei derartigen Systemen wird die Schleusenkammer und die Prozesskammer bzw. mehrere Kammern um die im wesentlichen zentrale Transportkammer peripher angeordnet. Bei mehr als einer Schleusenkammer und insbesondere bei mehreren Prozesskammern werden diese Kammern in einer Art sternförmigen Anordnung um die zentral liegende Transportkammer angeordnet. Die Transporteinrichtung befindet sich dann in dieser zentral liegenden Transportkammer und hat Zugriff einerseits auf die mindestens eine Schleusenkammer und andererseits auf die Prozesskammern. Zwischen der Transportkammer und den übrigen Kammern wird üblicherweise und bevorzugt ein sogenanntes Schleusenventil angeordnet, um die Kammern gegeneinander beim Schleusenvorgang bzw. beim Prozessschritt gegeneinander abschotten zu können. Beim Transportvorgang eines Wafers greift dann die Transporteinrichtung entsprechend durch die offenen Schleusentore hindurch, um den Wafer am gewünschten Ort abzulegen. Schleusenkammern und abtrennbare Prozesskammern dienen dazu, einerseits verschiedene Atmosphären gegeneinander zu trennen und insbesondere um Verschleppungen von unerwünschten Verunreinigungen, welche zu Kontaminationen in den Bearbeitungsprozessen führen würden.

In derartigen Vakuumprozessen, wie insbesondere zur Abscheidung von dünnen Schichten, spielt die Sauberkeit und die Qualität der Substratoberfläche eine wichtige Rolle und beeinflusst die beispielsweise abgeschiedene Schicht in ihrer Qualität ganz wesentlich. In Vakuumümgebung sind wichtige Stoffe, die auf einem Substrat gefunden werden können, Wasser bzw. Wasserdampf und organische Materialien. Derartige kontaminierende Stoffe sind auf der Oberfläche des Substrates absorbiert und werden üblicherweise entfernt durch Erhöhen des Dampfdrukkes dieses kontaminierenden Stoffes, beispielsweise durch Erhöhung der Temperatur. Eine derartige Temperaturerhöhung wird beispielsweise erzeugt durch infrarote Bestrahlung oder durch Heizen des Substrates über Konduktion also Wärmeleitung. Wenn die erhöhte Temperatur am Substrat erreicht ist, wird ein zusätzlicher effektiver Pumpmechanismus benötigt, um die von der Substratoberfläche abströmenden Verunreinigungen, welche nun in Gasform vorliegen, abpumpen zu können. Gewöhnlich wird dies dadurch erreicht, indem auf tiefe Vakuumdrücke abgepumpt wird.

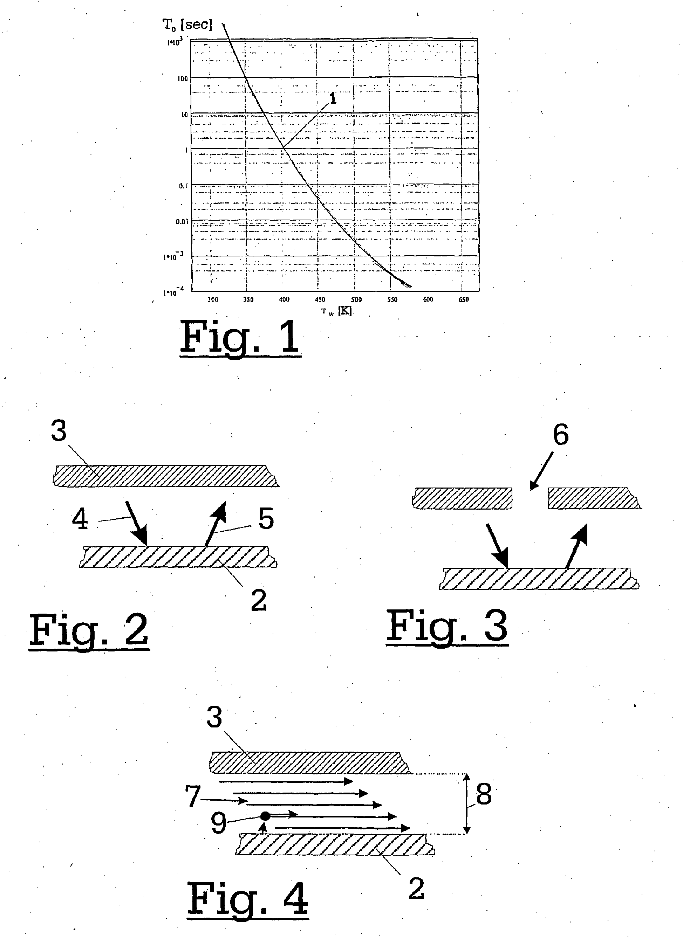

Ein Beispiel für das Abgasungsverhalten einer mit Wasserdampf gesättigten Metalloberfläche ist in der Fig. 1 dargestellt. Die Kurve 1 zeigt das Verhalten der Verweilzeit $t_0$ des Wasserdampfes auf der Metalloberfläche abhängig von der Oberflächentemperatur $T_w$ des Substrates. Die Verweilzeit $t_0$ als Funktion der Substrattemperatur Tw eines Adsorbates auf der Oberfläche folgt der Formel:

$$\tau(T_W) = \tau_0 \cdot e^{\frac{E_{ads}}{N_A \cdot k_b \cdot T}}$$

Wobei $N_A$ die avogadrosche Konstante ist, $k_b$ die boltzmannsche Konstante, $\tau_0$ die charakteristische Vibrationsperiode von Festkörpermaterial (approx. $10^{-13}$ sec) und $E_{ads}$ die Absorptionsenergie von Wasser auf Metall (approx. $10^5$ j). Für das Verhalten von Substraten in Vakuumsystemen hat eine ähnliche Kurve Gültigkeit. In Fig. 2 ist eine Anordnung dargestellt mit zwei parallelen Platten, in welchem die eine Platte das Substrat 2 ist und die andere Platte die Umgebung 3 darstellt. Es kann ein Gasfluss 4 hin zum Substrat und ein Gasfluss 5 weg vom Substrat angenommen werden. Wenn das System ein Gleichgewicht erreicht nach einer gewissen Verweilzeit kann eine maximale Gasentfernungseffizienz erreicht werden basierend auf der Temperaturdifferenz zwischen dem Substrat 2 und der Umgebung 3. Die Gasentfernung wird hierbei sich nicht mehr verändern unabhängig davon, wie lange der Prozess fortgeführt wird. Um das Gleichgewicht hin zur tiefsten Absorbatkonzentration auf dem Substrat zu verschieben, wird wie erwähnt in bekannter Weise über eine Pumpanordnung, hier mit der Pumpöffnung 6 in Fig. 3 schematisch dargestellt, abgepumpt. In diesem Fall ist die Absorbatkonzentration proportional zum Temperaturgleichgewicht und dem tatsächlich entfernten Absorbat aus dem System. Dies ist letzlich abhängig von der Pumpleistung, der Pumpöffnung 6 und der Zeit. Eine grössere Pumpleistung oder eine längere Pumpzeit führt folglich zu besseren Resultaten. Wie aber bereits erwähnt, führt dies zur Notwendigkeit von grossen Pumpen, lange Pumpzeiten oder hohen Temperaturen. Ultrahochvakuumpumpen und Temperaturen um die 400° Celsius sind nicht ungewöhnlich beim Einsatz in solchen Systemen, um eine genügend kurze, beispielsweise 30 s dauernde, Prozesszeit zu erreichen für die Ausgaszyklen.

Bei Systemen, die auf Strahlungsheizung basieren, müssen hohe Energiewerte im System aufgewendet werden, um den geringen Heizwirkungsgrad eines solchen Systemes zu kompensieren. Als einzelne Entgasungseinheit kann ein solches System einigermassen funktionieren. Als Entgasungskomponente oder -modul, welches in ein grösseres System eingebettet ist, führen die Kühlungserfordernisse für ein solches System zu sehr teuren und komplizierten Anordnungen. Das Substrat ist ausserdem in vielen Fällen eines der kältesten Elemente in seiner Umgebung und zeigt in der Folge kein gutes Entgasungsverhalten.

Konduktive Heizanordnungen bzw. Heizanordnungen mit Wärmeleitung sind an sich ein besserer Ansatz. Das Substrat ist hierbei üblicherweise auf einen geheizten Körper aufgeklemmt, wobei zwischen Körper und Substrat ein Gas eingeführt wird, um Wärmeleitung vom Körper auf das Substrat zu erzeugen. Das Pumpsystem wird benutzt, die Kontaminierungen zu Entfernen, welche von der Seite stammen, die nicht dem Kontaktgas ausgesetzt ist.

Beide dieser Techniken sind Hochvakuummethoden. Die Effektivität des Systems ist wesentlich bestimmt durch die Effizienz des Pumpsystems. Je besser das Vakuum in der Umgebung ist, um so besser ist der Entgasungseffekt des Systems. Dies führt allerdings zu sehr grossen und sehr teuren Pumpsystemen. Ausserdem werden längere Bearbeitungszeiten zur Entfernung des Absorbates benötigt. Dies führt wiederum zu sehr langen unerwünschten Prozesszeiten, welches die Wirtschaftlichkeit des Produktionssystemes verringert. Bei Verwendung von höheren Temperaturen könnte die Prozesszeit verkürzt werden, was allerdings in vielen Fällen unerwünscht oder gar nicht möglich ist wegen der Empfindlichkeit derartiger Substrate.

Die Aufgabe der vorliegenden Erfindung liegt darin, die vorerwähnten Nachteile des Standes der Technik zu beseitigen. Insbesondere besteht die Aufgabe darin, eine Vorrichtung und ein Verfahren zur Entgasung von scheibenförmigen Substraten, insbesondere von Halbleiterscheiben, zu realisieren, welche eine hohe Effektivität aufweist und die Bearbeitungszeit verkürzen lässt bei schonender Behandlung des Substrates, womit eine hohe Wirtschaftlichkeit im Produktionsprozess erreicht werden kann.

Die Aufgabe wird erfindungsgemäss durch eine Vorrichtung zur Entgasung von scheibenförmigen Substraten, nach Anspruch 1 gelöst und mit einem Verfahren nach Anspruch 13. Die abhängigen Ansprüche definieren weitere vorteilhafte Ausführungsformen.

Die Lösung der vorliegenden Aufgabe besteht erfindungsgemäss darin, dass die Vorrichtung zur Entgasung eines scheibenförmigen Substrates, wie insbesondere eines Halbleiter-Wafers, in einer evakuierten Umgebung 2 im Wesentlichen flache parallele Körper umfasst, welche beabstandet angeordnet sind und wobei der Abstand kleiner ist als die Längenausdehnung bzw. der Durchmesser der Körper und dass dadurch ein Zwischenraum ausgebildet wird in welchem das Substrat zwischen den Körpern angeordnet ist und von diesen im Randbereich mindestens überragt wird, wobei in mindestens einem der Körper eine Gaszuführung angeordnet ist zur Erzeugung eines laminaren Gasflusses im Zwischenraum entlang der Körper und entlang des Substrates in radialer Richtung hin zur Peripherie der Körper und dass dort eine Pumpöffnung vorgesehen ist zum Abpumpen des Gasflusses.

Die geometrische Ausbildung der Anordnung und die Einstellung der Gasflussverhältnisse sollen hierbei derart erfolgen, dass zwischen den plattenförmigen Körpern über der Substratoberfläche eine Gasströmung erreicht wird, die im laminaren Bereich liegt und dass das Gasvolumen zwischen den Körpern über die Prozesszeit mehrfach ausgewechselt wird. Laminarer Gasfluss ist dann erstellt, wenn die Bewegung des Gases parallel zur Substratoberfläche gasflussgetrieben ist und jeglicher Massentransfer senkrecht zum Substrat diffusionsgetrieben ist. Derartige Verhältnisse können erstellt werden, indem bei vorgegebener Abmessung des Substrates und somit vorgegebener Abmessung der Körper dessen Abstand bzw. die Spaltbreite des gebildeten Zwischenraums derart gewählt wird, dass bei entsprechender Ausbildung der Gaszuführung und der Druckverhältnisse, welche die Gasmenge zusammen mit der Pumpleistung bestimmen, die gewünschte laminare Strömung auftritt. Für den Entgasungsvorgang wird zusätzlich mit einer Heizung, die beispielsweise innerhalb einer oder beider Platten angeordnet ist, das Substrat aufgeheizt, um den Entgasungsvorgang zusätzlich zu beschleunigen. Mit einer derartigen Entgasungsvorrichtung kann der Grad der Entgasung wesentlich verbessert werden und / oder die Entgasungsdauer wesentlich verkürzt werden, beispielsweise um mehr als den Faktor 2 verbessert werden. In einer typischen Behandlungsanlage für Halbleiter-Wafer wird die Prozesszeit für die einzelnen Behandlungsschritte massgeblich den Durchsatz der Anlage und somit deren Wirtschaftlichkeit bestimmen. Hierbei ist insbesondere derjenige Prozessschritt bestimmend, welcher am längsten dauert. Bisher war dies oft der Prozessschritt, welcher notwendig war für die Entgasung des Substrates. Ein einfacher Prozess, wie dies im Prinzip das Entgasen darstellt, sollte nicht bestimmend und limitierend für den Anlagendurchsatz sein. Bei praktischen Ausführungen derartiger Halbleiterprozesssysteme sollte ein derartiger Entgasungsschritt beispielsweise innerhalb etwa 30 s abgeschlossen sein, so dass für die übrigen verbleibenden Prozessschritte bzw. für den Prozesstakt etwa 50 s ermöglicht werden. Die 20 s Zeitdifferenz werden benötigt für den Pumpvorgang und den Transport bzw. das Handling des Substrates.

Die Erfindung wird nun nachfolgend beispielsweise und mit schematischen Figuren näher erläutert. Es zeigen:

Fig. 4 ein Ausschnitt im Querschnitt von parallel angeordnetem flachem Substrat und beabstandet angeordnetem flachem Körper mit dazwischen liegender laminarer Gasströmung entsprechend der Erfindung;

Fig. 5 eine Anordnung der Erfindung schematisch im Querschnitt;

Fig. 6 ein Beispiel für die Gaszuführung;

Fig. 7 ein Detail einer Gaszuführungsöffnung im Querschnitt gemäss der Gaszuführung nach Fig. 6;

Fig. 8 im Querschnitt schematisch eine Entgasungsanordnung mit Heizelementen angeordnet in beiden Körpern;

Fig. 9 schematisch im Querschnitt eine Entgasungsanordnung mit einem Heizelement angeordnet im Körper, bei dem das Substrat aufliegt;

Fig. 10 schematisch im Querschnitt eine Entgasungsanordnung mit einem Heizelement angeordnet im Körper, der der Substratoberfläche gegenüber liegt;

Fig. 11 ein Diagramm mit Darstellung des Restwassergehaltes am Substrat abhängig von der Temperatur dargestellt mit laminarer Gasflussanordnung entsprechend der Erfindung und ohne Gasfluss entsprechend dem Stand der Technik;

Gemäss der verbesserten Methode, die Absorbate effektiver abführen zu können, entsprechend der vorliegenden Erfindung, wird die Absorbatkonzentration im Bereich der Substratoberfläche derart beeinflusst, dass der Absorbatfluss 4, wie in Fig. 2 dargestellt, welcher gegen das Substrat 2 gerichtet ist, möglichst entfernt bzw. vermindert wird und dadurch das erwähnte Gleichgewicht verschoben wird.

Wird nun im Bereich der Substratoberfläche des Substrates 2 ein Gasfluss von nicht absorbierendem Gas 7 erstellt mit einem laminaren oder turbulentem Gasflussregime, verändert sich das zuvor vorgestellte Modell mit der Gleichgewichtsbetrachtung signifikant. Eine derartige Anordnung ist schematisch und im Querschnitt in Fig. 4 dargestellt. Wenn der Gasfluss zwischen zwei Platten laminar oder turbulent ist, dann ist die freie Weglänge der Gasteilchen im Gas wesentlich kleiner als die charakteristische Abmessung des Systems, also dem Abstand 8 zwischen dem Substrat 2 und der gegenüberliegenden angeordneten Platte 3. Dies gilt auch für die kurze freie Weglänge für abdampfende Absorbate von der Oberfläche des Substrates, womit jedes vom Substrat 2 verdampfende Material 9 Teil des Gasflusses 7 wird, sobald es die Oberfläche des Substrates verlassen hat. Sobald nun die Temperatur des Substrates auf einen Wert gebracht wird, wo die Verweilzeit des Absorbates sehr kurz ist im Vergleich mit der typischen Prozesszeit, kann man davon ausgehen, dass das Absorbat elastische Kollosionen mit der Oberfläche des Substrates bildet und hierdurch ein integraler Bestandteil des inerten Gasflusses, welches das Substrat umgibt, bildet. Dies ist dann der Fall, wenn beispielsweise für einen 30 s Prozessschritt die Verweilzeit Hundertstel von s erreicht. Derartige Verweilzeiten können erreicht werden, wenn Temperaturwerte erreicht werden, beispielsweise entsprechend der Kurve 1 nach der Fig. 1, also Temperaturen von 430 bis 480° Kelvin, was etwa 160 bis 200° Celsius entspricht. Wenn diese Temperaturen erreicht sind und die desorbierte Spezie ein integraler Teil des Gasflusses 7 wird, ist der Wegtransport dieser Spezie nur noch von der Gasflussrate abhängig. Aus diesem Grund muss ein Gasfluss erzeugt werden, der einen vollständigen Gaswechsel im Volumen im Bereich des Substrates erzeugt innerhalb der gewählten Prozesszeit. Es ist vorteilhaft, den Gäswechsel mehrere Male vorzunehmen, vorzugsweise mehr als 5fach, um sicher zu stellen, dass die Adsorbate vollständig entfernt werden. Zur Erzeugung eines Gasflusses sollen bevorzugt Inert-Gase verwendet werden, wobei Argon besonders günstig ist.

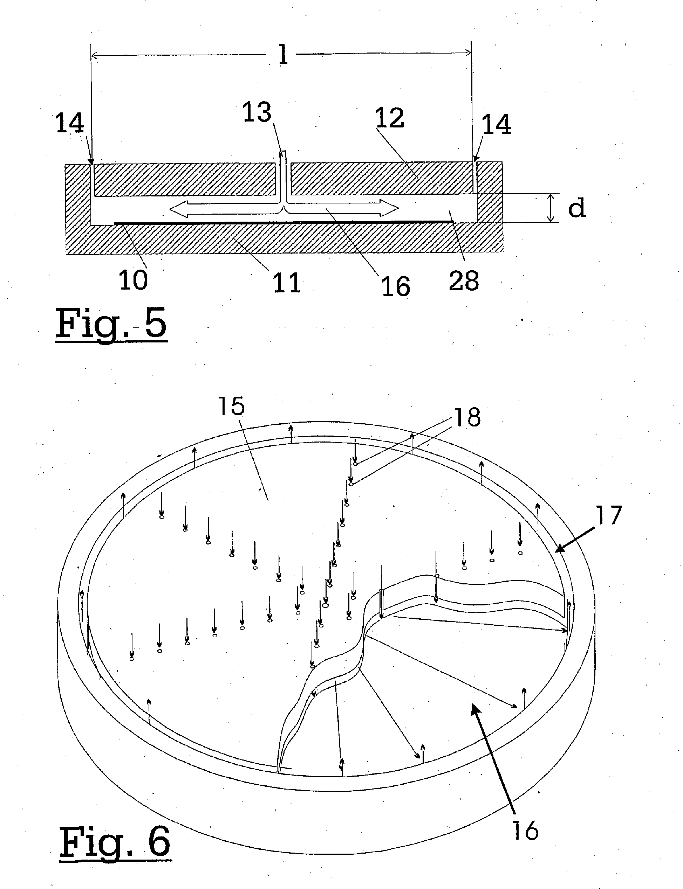

Eine vorteilhafte Ausführung der Erfindung besteht darin, das Substrat 10, welches entgast werden soll, zwischen zwei Körper 11, 12 mit der Ausdehnung 1 anzuordnen, welche beabstandet sind mit dem Abstand d und dort einen Zwischenraum 28 bilden, wie dies in Fig. 5 im Querschnitt dargestellt ist. Hierbei soll das Substrat 10 auf eine erhöhte Temperatur wie von beispielsweise 200° Celsius mit einer Heizeinrichtung gebracht werden. Zwischen dem mindestens einen Körper 11, 12 und dem Substrat 10 soll ein Gasfluss 13 erzeugt werden, der einen laminaren Gasfluss bildet über die gesamte Oberfläche des Substrates 10. Im Randbereich des Substrates 10 bzw. des mindestens einen Körpers 11, 12 ist eine Pumpöffnung 14 angeordnet, welche vorteilhafterweise das Substrat 10 umgibt, durch welche das Gas zusammen mit dem Kontaminationsgas abgepumpt wird und dadurch aus dem System entfernt wird. Für runde Substrate 10, wie für die bevorzugten Halbleiter-Wafer oder Speicherplatten, kann das Gas für die Gaszuführung 13 durch einen Körper 15 mit Öffnungen 18 eingedüst werden, die derart angeordnet sind, dass ein radialer Fluss 16 vom Zentrum gegen die Peripherie erstellt wird. Diese Anordnung kann kombiniert werden mit einer zirkular an der Peripherie angeordneten Pumpöffnung 17 oder mit mehreren Öffnungen, welche zirkular angeordnet sind. Mit dieser zirkular angeordneten Pumpöffnung 17 wird die Pumpgeschwindigkeit der Pumpanordnung bestimmt bzw. begrenzt, derart dass die Gasflussausbildung im wesentlichen durch den Gasfluss und nicht durch die Pumpabmessungen bestimmt wird, wie dies beispielsweise in der dreidimensionalen Darstellung nach Fig. 6 gezeigt ist.

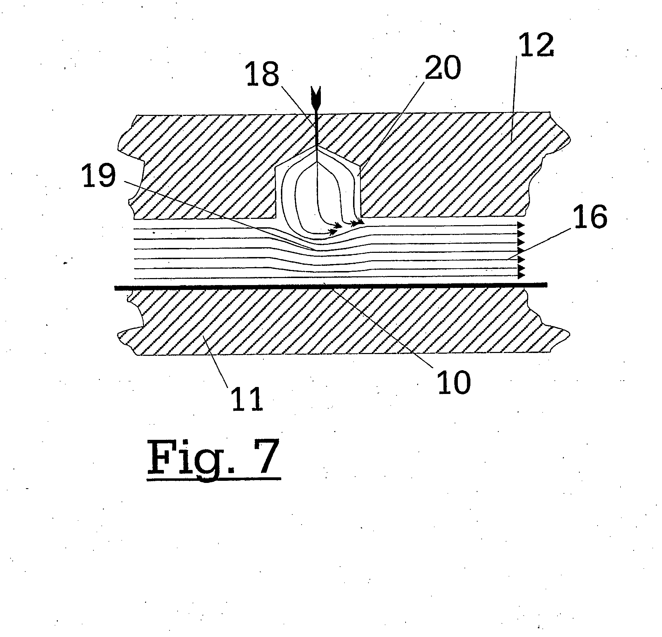

Der Gasfluss zwischen dem Substrat 10 und dem Körper 11, 12 sollte möglichst ungestört laminar sein, um den Kontaminationsgasfluss zurück zum Substrat 10 zu minimalisieren. Dadurch entstehen spezielle Anforderungen an die Ausbildung des oder der Gasinjektionspunkte im Bereich über dem Substrat 10. Ein Beispiel einer bevorzugten Einlassanordnung mit einem Gaszuführungspunkt ist im Querschnitt in Fig. 7 dargestellt. Derartige Gasinjektionspunkte sollten einen vorbestimmten definierten Gasfluss erzeugen und deshalb sollten diese derart ausgebildet werden, dass dieser definierte Gasfluss pro Injektionspunkt durch seine Ausbildung selbstbestimmend ist. Um dieses Erfordernis erfüllen zu können, werden für die Gasinjektionspunkte sehr kleine Öffnungen 18 vorgesehen, um in diesem Bereich eine hohe Gasgeschwindigkeit erzielen zu können. Dadurch wird wiederum in diesen Bereichen die laminare Gasflussausbildung bzw. -verteilung 19 signifikant gestört. Wie erwähnt sollte dies vermieden werden und es ist notwendig, die Geschwindigkeit des eindüsenden Gases durch die Öffnung 18 zu reduzieren, indem die Öffnung 18 mit sehr kleinem Durchmesser in einem Bereich mündet mit wesentlich erweitertem Durchmesser 20, welcher den Auslass der Düse bildet, die in den Bereich der laminaren Gasströmung 16 einmündet. Mit Hilfe dieser Massnahme kann das eingedüste Gas auf einen Geschwindigkeitslevel abgesenkt werden, welche die laminare Strömung des Gasflusses im Bereich des Substrates 10 nicht wesentlich stört.

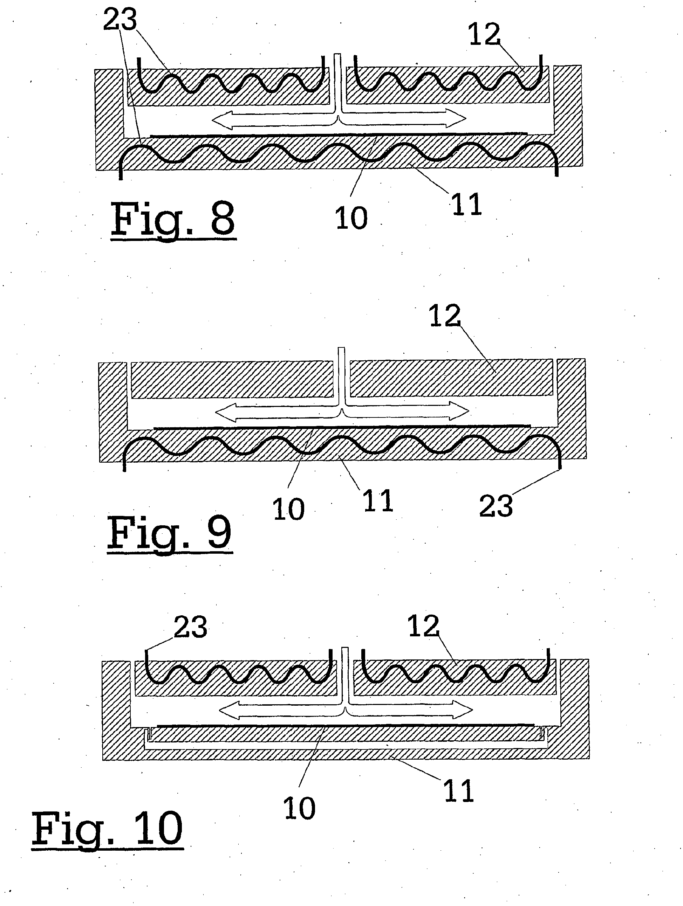

In einer weiteren Ausbildung der Erfindung werden beide Körper 11, 12, welche das Substrat 10 umgeben, mit Heizelementen 23 versehen, um die Körper 11, 12 aufzuheizen und dadurch das Substrat 10 zu heizen, wie dies in Fig. 8 im Querschnitt schematisch dargestellt ist. In einer weiteren Variante gemäss Fig. 9 wird nur der eine Körper 12, auf welchem das Substrat 10 liegt und welches somit im Kontakt mit diesem Körper ist, geheizt. In einer weiteren bevorzugten Variante entsprechend der Darstellung nach Fig. 10 wird bevorzugt der dem Substrat gegenüberliegende Körper 11, 12 geheizt, wobei das Substrat 10 selbst auf dem unten liegenden Körper 11 thermisch floatend, also im wesentlichen isoliert, angeordnet ist. Mit dieser Anordnung kann eine besonders einfache Ausführung einer Entgasungsstation realisiert werden.

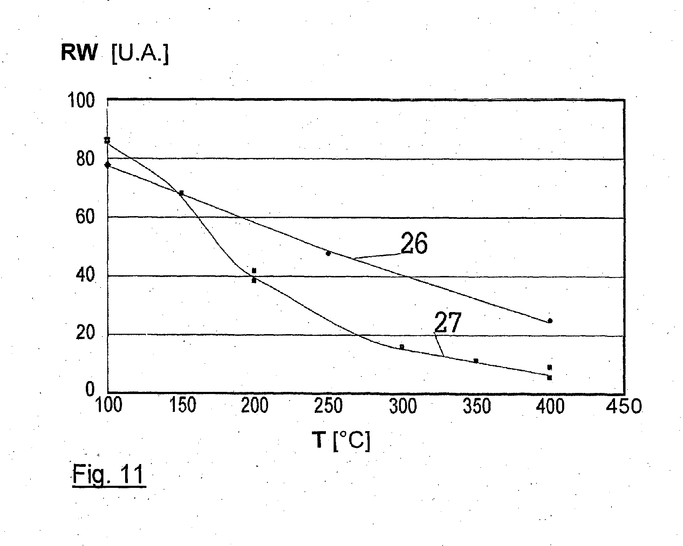

Eine Charakterisierung des vorteilhaften Ergebnisses des Verfahrens ist in Fig. 11 dargestellt. Das am Substrat 10 verbleibende Restwasser RW, auch residual gas, ist nach dem Entgasen als Funktion der Substrattemperatur T in ° Celsius dargestellt, wobei das Restwasser RW normiert angegeben wird (arbitrary unit U.A.). Die Kurve 26 zeigt den Effekt ohne Gas gemäss Stand der Technik und die Kurve 27 zeigt den Effekt entsprechend der vorliegenden Erfindung unter Verwendung der Anordnung mit laminarer Gasströmung 16. Als Trägergas für die laminare Gasströmung wurde Argon verwendet. Es ist deutlich zu sehen, dass bei Temperaturen ab 150° Celsius mit der vorliegenden erfinderischen Anordnung das Restgas vom Substrat wesentlich effektiver abgeführt wird und am Substrat 10 somit bei gleicher Anordnung und über die gleiche Zeitdauer wesentlich weniger Restgas verbleibt.

Die Betriebstemperatur der Entgasungseinrichtung bzw. des Substrates 10 kann bestimmt werden durch die Verweilzeit des Wassers auf der Waferoberfläche und der gewünschten zu erzielenden Prozesszeit. Ab 100° Celsius werden günstige Entgasungswerte erreicht, wo die absorbierten Stoffe am Substrat genügend rasch abgegeben werden können in dem laminaren Gasfluss, um durch diesen entfernt werden zu können. Die obere Betriebstemperatur wird einerseits bestimmt durch die Möglichkeiten der praktischen Ausführung, andererseits durch die Zulässigkeit von empfindlichen Substraten und weiter durch den Nutzen der dadurch erzielt wird. Hierbei wurde erkannt, dass eine geeignete obere Temperaturlimite bei 400° Celsius liegt. Über dieser Temperatur kann mit der Entgasungsvorrichtung keine signifikante Verbesserung der Wirkung erzielt werden. Wie bereits erwähnt, ist für die Einstellung des Arbeitsbereiches für den Gasfluss wesentlich, dass die parallele Plattenanordnung der Heizer zusammen mit dem Substrat 10 einen laminaren Gasfluss ermöglicht. Zusätzlich ist dafür zu sorgen, dass über die Prozesszeit eine bestimmte Gaswechselrate im Zwischenraum 28 der plattenförmigen Körper 11, 12 erzielt wird. Die Gaswechselrate ist hierbei die Anzahl der Gaswechsel, bei welchem der Inhalt des Volumens des Zwischenraumes 28 vollständig ersetzt wird. Der optimierte Gasflussbereich wird dadurch im grossen Masse durch die konstruktive Ausbildung der Anordnung abhängig. Günstige Anordnungen können dann realisiert werden, wenn der totale Gasfluss im Bereich von 300 sccm bis 1000 sccm und die Gaswechselrate im Bereich von 5 bis 15-fach ist bei einer Prozesszeit von bis zu 30 s. Um ein Regime eines laminaren Gasflusses aufrecht zu erhalten, ist in diesem Bereich ein Arbeitsdruck von 10 bis 50 mbar notwendig. Die untere Grenze wird hierbei durch die Knudsen/Molekularflussregion bestimmt. Die obere Grenze ist definiert durch die Reynolds-Zahl bei dieser Geometrie der Anordnung. Wenn der Druck weiter erhöht wird, erscheint der Bereich der turbulenten Strömung. Wie bereits erwähnt ist der laminare Bereich für optimale Wirkung stark bevorzugt. Die Anordnung ist besonders gut geeignet für das Entgasen von Halbleiter-Wafern aber auch von Speicherplatten mit einem Durchmesser von grösser 150 mm, wobei diese Substrate scheibenförmig sind und Dicken von Zehntel mm bis mm aufweisen. Die Anordnung ist besonders geeignet für Scheibendurchmesser im Bereich von 150 bis 300 mm. Es können auch Scheiben bearbeitet werden, die grösser als 300 mm sind, wobei in diesem Fall der Aufwand drastisch steigt und die Ergebnisse weniger wirtschaftlich sind. Der Körperabstand d zwischen den plattenförmigen Körpern 11, 12 liegt im Bereich von 5 bis 30 mm, ist aber vorzugsweise von 8 bis 15 mm zu wählen zur Erstellung einer geeigneten laminaren Strömung. Für die Handhabung ist es günstig, wenn die Anordnung horizontal ausgebildet wird und das Substrat 10 auf die untere Platte 11 abgelegt wird und die obere Platte 12 eine Gasdusche enthält mit einer Heizanordnung mit einer thermischen Leistung bis etwa 1200 Watt.

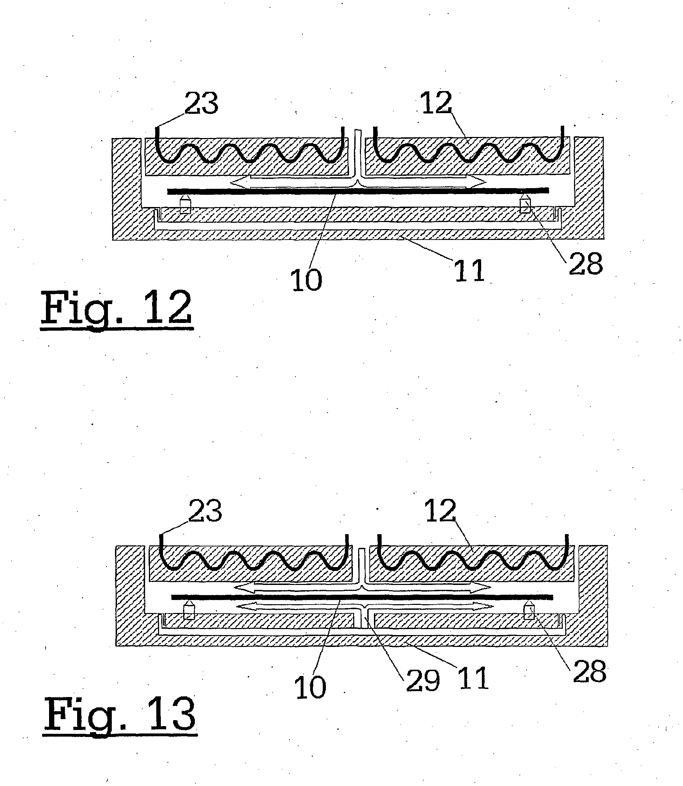

Eine besonders gute Wirkung der Entgasung wird ermöglicht wenn diese beidseits des Wafers erfolgen kann. Dazu wird der Wafer 10 auf mindestens drei Pins 28, das sind kleine Stifte mit Spitzen, positioniert abgelegt, derart dass der Wafer 10 vom plattenförmigen darunter liegenden Körper 11 ähnlich beabstandet wird, wie zuvor beschrieben für die Oberseite des Wafers, wie dies in den Figuren 11 und 12 dargestellt ist. Dadurch kann der Wafer 10 von desorbierten Gasen, sowohl auf der oberen Seit, wie auch auf der unteren Seite, effizient gereinigt bzw. entgast werden. Eine derartige Vorrichtung ist deshalb besonders bevorzugt. Eine weitere Verbesserung besteht darin, dass wie zuvor für die Oberflächenentgasung beschrieben ein ähnlicher laminarer unterer Gasfluss 29 im Spalt zwischen Wafer 10 und unterem Körper 11 erzeugt wird, wie dies in Figur 12 dargestellt ist. Die Gaszufuhr erfolgt hierbei ebenfalls, wie zuvor für die Oberseitenbehandlung beschrieben, über kleine verteilte Öffnungen 18 an dem unteren Körper 11. Diese kombinierte Anordnung ermöglicht nun ein effizientes vollständiges Entgasen des gesamten Wafers 10.

Mit der vorliegenden Anordnung ist es möglich, eine vollautomatisierte Halbleiterbearbeitungsprozessanlage zu realisieren, welche eine effektive Entgasung zwischen den einzelnen Prozessschritten ermöglicht unter Anwendung von bewährten Transport-Roboter-Systemen unter Erzielung entsprechend wirtschaftlicher Durchsätze.

**Patentansprüche**

1. Vorrichtung zur Entgasung eines plattenförmigen Substrates (10) in einer evakuierten Umgebung mit zwei im wesentlichen flachen, parallelen Körpern (11, 12), welche einen Abstand (d) aufweisen, der kleiner ist als ihre Längenausdehnung (1) einen Zwischenraum (28) bildend und dass das Substrat (10) zwischen den Körpern (11, 12) angeordnet ist und von diesen im Randbereich mindestens überragt wird, wobei in mindestens einem der Körper (11, 12) eine Gaszuführung (13) angeordnet ist zur Erzeugung eines Gasflusses im Zwischenraum (28) entlang der Körper (11, 12) und des Substrates (10) in radialer Richtung zur Peripherie der Körper (11, 12) und dass dort eine Pumpöffnung (14) vorgesehen ist zum Abpumpen des Gasflusses, wobei die Gaszuführung mindestens an einem der Körper (11, 12) mit mehreren Öffnungen (18) ausgebildet ist zur Ausbildung einer Gasdusche, und die Öffnungen (18) über die Oberfläche des mindestens einen Körpers (11, 12) verteilt angeordnet sind **dadurch gekennzeichnet, dass** der Gasfluss als laminarer Gasfluss erzeugbar ist indem die Vorrichtung derart ausgeführt ist, dass:

   - die Öffnungen 18 mit sehr kleinem Durchmesser jeweils in einen Bereich münden mit wesentlich erweitertem Durchmesser 20, welcher den Auslass der Düse bildet, die in den Bereich der zu erzeugenden laminaren Gasströmung einmündet;
   - der Abstand (d) im Bereich von 5 mm bis 30 mm liegt;
   - der laminare Gasfluss im Bereich von 300 sccm bis 1000 sccm einstellbar ist;
   - ein Arbeitsdruck im Bereich von 10 bis 50 mbar einstellbar ist.

2. Vorrichtung nach Anspruch 1 **dadurch gekennzeichnet, dass** eine Heizung (23) vorgesehen ist zur Heizung des Substrates (10).

3. Vorrichtung nach Anspruch 2 **dadurch gekennzeichnet, dass** die Heizung (23) als elektrisches Heizelement ausgebildet ist, vorzugsweise als Widerstandsheizelement und dieses vorzugsweise in einem der Körper (11, 12) oder in beiden Körpern (11, 12) integriert ist.

4. Vorrichtung nach einem der Ansprüche 2 oder 3 **dadurch gekennzeichnet, dass** die Heizung (23) zur Erzeugung einer Temperatur von 100° Celsius bis 400° Celsius am Substrat (10) ausgelegt ist.

5. Vorrichtung nach einem der vorhergehenden Ansprüche **dadurch gekennzeichnet, dass** der Abstand (d) im Bereich von 8 mm bis 15 mm vorliegt.

6. Vorrichtung nach einem der vorhergehenden Ansprüche **dadurch gekennzeichnet, dass** der Substratdurchmesser grosser 150 mm ist, vorzugsweise 150 mm bis 300 mm.

7. Vorrichtung nach Anspruch 6 **dadurch gekenn-**

**zeichnet, dass** das Substrat (10) scheibenförmig ist, vorzugsweise eine Speicherplatte, insbesondere ein Halbleiter-Wafer.

8. Vorrichtung nach einem der vorhergehenden Ansprüche **dadurch gekennzeichnet, dass** die flachen Körper (11, 12) im wesentlichen horizontal angeordnet sind und das Substrat (10) vorzugsweise auf den unten liegenden plattenförmigen Körper (11) abgelegt ist.

9. Vorrichtung nach einem der vorhergehenden Ansprüche **dadurch gekennzeichnet, dass** die flachen Körper (11, 12) im wesentlichen horizontal angeordnet sind und das Substrat (10) vorzugsweise auf mindestens drei Pins (28) abgelegt ist welche am unten liegenden plattenförmigen Körper (11) angebracht sind und einen spaltförmigen Abstand festlegen.

10. Vorrichtung nach einem der vorhergehenden Ansprüche **dadurch gekennzeichnet, dass** beidseits des Substrates (10)eine Gaszuführung (13) vorgesehen ist mit laminarem radialem Gasfluss.

11. Vorrichtung nach einem der vorhergehenden Ansprüche **dadurch gekennzeichnet, dass** die Gaszuleitung (13) im wesentlichen zentrisch zu mindestens einem der Körper (11, 12) in den Zwischenraum (28) führend angeordnet ist.

12. Vorrichtung nach einem der vorhergehenden Ansprüche **dadurch gekennzeichnet, dass** die Öffnungen (18) am oben liegenden Körper (12) ausgebildet sind.

13. Vorrichtung nach Anspruch 12 **dadurch gekennzeichnet, dass** die Öffnungen (18) verschiedene Öffnungsdurchmesser an der dem Zwischenraum (28) zugewandten Seite aufweisen.

14. Vorrichtung nach einem der vorhergehenden Ansprüche **dadurch gekennzeichnet, dass** die Gaszuführung (13) ausgelegt ist um innerhalb einer Prozesszeit von 30 s im Bereich 5 bis 15 Gaswechsel auszuführen.

15. Verfahren zur Entgasung eines plattenförmigen Substrates (10) in einer evakuierten Umgebung mit zwei im wesentlichen flachen, parallelen Körpern (11, 12), welche einen Abstand (d) aufweisen, der kleiner ist als ihre Längenausdehnung (1) einen Zwischenraum (28) bildend und dass ein flaches Substrat (10) zwischen den Körpern (11, 12) angeordnet wird, wobei in mindestens einem der Körper (11, 12) eine Gaszuführung (13) angeordnet ist zur Erzeugung eines Gasflusses im Zwischenraum (28) entlang der Körper (11, 12) und des Substrates (10) in radialer Richtung zur Peripherie der Körper (11, 12) und dass dort über eine Pumpöffnung (14) der Gasfluss abgepumpt wird, wobei die Gaszuführung mindestens an einem der Körper (11, 12) mit mehreren Öffnungen (18) ausgebildet ist zur Ausbildung einer Gasdusche, und die Öffnungen (18) über die Oberfläche des mindestens einen Körpers (11, 12) verteilt angeordnet sind **dadurch gekennzeichnet, dass** der Gasfluss ein laminarer Gasfluss ist indem:

- die Öffnungen 18 mit sehr kleinem. Durchmesser jeweils in einen Bereich münden mit wesentlich erweitertem Durchmesser 20, welcher den Auslass der Düse bildet, die in den Bereich der laminaren Gasströmung einmündet;
- der Abstand (d) im Bereich von 5 mm bis 30 mm liegt;
- der laminare Gasfluss im Bereich von 300 sccm bis 1000 sccm liegt;
- ein Arbeitsdruck im Bereich von 10 bis 50 mbar liegt.

16. Verfahren nach Anspruch 15 **dadurch gekennzeichnet, dass** das Substrat (10) mit einer Heizung (23) geheizt wird.

17. Verfahren nach Anspruch 16 **dadurch gekennzeichnet, dass** die Heizung (23) als elektrisches Heizelement betrieben wird, vorzugsweise als Widerstandsheizelement und dieses vorzugsweise in einem der Körper (11, 12) oder in beiden Körpern (11, 12) integriert betrieben wird.

18. Verfahren nach einem der Ansprüche 15 oder 16 **dadurch gekennzeichnet, dass** das Substrat (10) auf eine Temperatur von 100° Celsius bis 400° Celsius geheizt wird.

19. Verfahren nach einem der vorhergehenden Ansprüche 15 bis 18 **dadurch gekennzeichnet, dass** der Abstand (d) im Bereich von 8 mm bis 15 mm eingehalten wird.

20. Verfahren nach einem der vorhergehenden Ansprüche 15 bis 19 **dadurch gekennzeichnet, dass** ein Substrat (10) mit einem Durchmesser von grosser 150 mm entgast wird, vorzugsweise im Bereich von 150 mm bis 300 mm.

21. Verfahren nach einem der vorhergehenden Ansprüche 15 bis 20 **dadurch gekennzeichnet, dass** die flachen Körper (11, 12) im wesentlichen horizontal angeordnet werden und das Substrat (10) vorzugsweise auf mindestens drei Pins (28) abgelegt wird, welche am unten liegenden plattenförmigen Körper (11) angebracht sind und einen spaltförmigen Abstand festlegen.

**22.** Verfahren nach einem der vorhergehenden Ansprüche 15 bis 21 **dadurch gekennzeichnet, dass** beidseits des Substrates (10) eine Gaszuführung (13) vorgesehen wird zur Bildung eines laminaren radialen Gasflusses.

**Claims**

**1.** A device for degassing a plate-shaped substrate (10) in an evacuated environment with two substantially flat, parallel bodies (11, 12), spaced at a distance (d) smaller than their longitudinal extent (1) forming an interspace (28), and that the substrate (10) is arranged between the bodies (11, 12) and these project beyond the substrate at least at the periphery, wherein a gas delivery (13) is arranged in at least one of the bodies (11,12) for generating a gas flow in the interspace (28) along the bodies (11, 12) and the substrate (10) in radial direction towards the periphery of the bodies (11, 12), and that a pumping port (14) is provided there for pumping off the gas flow, wherein the gas delivery is formed at least on one of the bodies (11, 12) with several openings (18) for forming a gas shower, and the openings (18) are arranged distributed over the surface of the at least one of the bodies (11, 12), **characterised in that** the gas flow is generatable as a laminar gas flow by adapting the device such that:

- the openings (18) with very small diameter each open into a region with substantially expanded diameter (20), which forms the outlet of the nozzle, which opens into the region of the to be generated laminar gas flow;
- the distance (d) lies in the range from 5 mm to 3 mm;
- the laminar gas flow is adjustable in the range from 300 sccm to 1000 sccm;
- the working pressure is adjustable in the range from 10 to 50 mbar.

**2.** The device of claim 1, **characterised in that** a heating (23) is provided for heating the substrate (10).

**3.** The device of claim 2, **characterised in that** the heating (23) is formed as an electric heating element, preferably as a resistance heating element, and is preferably integrated in one of the bodies (11, 12) or in both bodies (11, 12).

**4.** The device of claim 2 or 3, **characterised in that** the heating (23) is adapted to generate a temperature from 100° Celsius to 400° Celsius on the substrate (10).

**5.** The device of one of the preceding claims, **characterised in that** the distance (d) is in the range from 8 mm to 15 mm.

**6.** The device of one of the preceding claims, **characterised in that** the substrate diameter is greater than 150 mm, preferably 150 mm to 300 mm.

**7.** The device of claim 6, **characterised in that** the substrate (10) has the form of a disk, preferably is a storage disk, in particular is a semiconductor wafer.

**8.** The device of one of the preceding claims, **characterised in that** the flat bodies (11, 12) are arranged essentially horizontally and the substrate (10) is preferably deposited on the subjacent plate-shaped body (11).

**9.** The device of one of the preceding claims, **characterised in that** the flat bodies (11, 12) are arranged essentially horizontally and the substrate (10) is preferably deposited on at least three pins (28), which are attached to the subjacent plate-shaped body (11) and define a gap.

**10.** The device of one of the preceding claims, **characterised in that** a gas delivery (13) having a laminar radial gas flow is provided on both sides of the substrate (10).

**11.** The device of one of the preceding claims, **characterised in that** the gas delivery (13) is arranged essentially centrally with respect to at least one of the bodies (11, 12), such that it leads into the interspace (28).

**12.** The device of one of the preceding claims, **characterised in that** the openings (18) are formed at the overlying body (12).

**13.** The device as claimed in claim 12, **characterised in that** the openings (18) have different opening diameters on the side facing the interspace (28).

**14.** The device of one of the preceding claims, **characterised in that** the gas delivery (13) is configured to accomplish in the range from 5 to 15 gas exchanges within a process time of 30 s.

**15.** A method for degassing a plate-shaped substrate (10) in an evacuated environment with two substantially flat, parallel bodies (11, 12), spaced at a distance (d) smaller than their longitudinal extent (1) forming an interspace (28), and that a flat substrate (10) is arranged between the bodies (11, 12), wherein a gas delivery (13) is arranged in at least one of the bodies (11, 12) for generating a gas flow in the interspace (28) along the bodies (11, 12) and the substrate (10) in radial direction towards the periphery of the bodies (11, 12), and that the gas flow is pumped off there through a pumping port (14), wherein the gas delivery is formed at least on one of the bodies (11, 12) with several openings (18) for forming a gas shower, and the openings (18) are arranged distributed over the surface of the at least one of the bodies (11, 12), **characterised in that** the gas flow is a laminar gas flow **in that**:

- the openings (18) with very small diameter each open into a region with substantially expanded diameter (20), which forms the outlet of the nozzle, which opens into the region of the laminar gas flow;
- the distance (d) lies in the range from 5 mm to 3 mm;
- the laminar gas flow is adjustable in the range from 300 sccm to 1000 sccm;
- the working pressure is adjustable in the range from 10 to 50 mbar.

16. The method of claim 15, **characterised in that** the substrate (10) is heated with a heating (23).

17. The method of claim 16, **characterised in that** the heating (23) is operated as an electric heating element, preferably as a resistance heating element, and is preferably operated integrated in one of the bodies (11, 12) or in both bodies (11, 12).

18. The method of claim 15 or 16, **characterised in that** the substrate (10) is heated to a temperature from 100° Celsius to 400° Celsius.

19. The method of one of the preceding claims 15 to 18, **characterised in that** the distance (d) is maintained in the range from 8 mm to 15 mm.

20. The method of one of the preceding claims 15 to 19, **characterised in that** a substrate (10) with diameter greater than 150 mm, preferably in the range from 150 mm to 300 mm, is degassed.

21. The method of one of the preceding claims 15 to 20, **characterised in that** the flat bodies (11, 12) are arranged essentially horizontally and the substrate (10) is preferably deposited on at least three pins (28), which are attached to the subjacent plate-shaped body (11) and define a gap.

22. The method of one of the preceding claims 15 to 21, **characterised in that** a gas delivery (13) is provided on both sides of the substrate (10) for generating a laminar radial gas flow.

**Revendications**

1. Dispositif de dégazage d'un substrat (10) en forme de plaque dans un environnement évacué avec deux corps (11, 12) parallèles sensiblement plats, lesquels présentent un écart (d) qui est inférieur à leur extension longitudinale (1) formant un interstice (28), dans lequel le substrat (10) est agencé entre les corps (11, 12) et dépassé par ces derniers au moins dans la zone du bord, une arrivée de gaz (13) étant agencée dans au moins un des corps (11, 12) pour produire un flux de gaz dans l'interstice (28) le long des corps (11, 12) et du substrat (10) dans le sens radial par rapport à la périphérie des corps (11, 12), et dans lequel il est prévu une ouverture de pompe (14) pour pomper le flux de gaz, l'arrivée de gaz étant réalisée sur au moins l'un des corps (11, 12) avec plusieurs ouvertures (18) pour créer un courant de gaz, et les ouvertures (18) étant agencées réparties sur la surface du au moins un corps (11, 12), **caractérisé en ce que** le flux de gaz peut être produit sous forme de flux de gaz laminaire dans la mesure où le dispositif est réalisé de façon à ce que:

- les ouvertures (18) de très petit diamètre débouchent respectivement dans une zone avec un diamètre essentiellement élargi (20), laquelle zone forme la sortie de la buse qui débouche dans la zone du courant de gaz laminaire à produire;
- la distance (d) est dans la plage allant de 5 mm à 30 mm;
- le flux de gaz laminaire peut être réglé dans la plage allant de 300 sccm à 1000 sccm;
- la pression de service peut être réglée dans la plage allant de 10 à 50 mbar.

2. Dispositif selon la revendication 1, **caractérisé en ce qu'**il est prévu un chauffage (23) pour chauffer le substrat (10).

3. Dispositif selon la revendication 2, **caractérisé en ce que** le chauffage (23) est réalisé sous la forme d'un élément chauffant électrique, de préférence sous la forme d'un élément chauffant à résistance et ce dernier étant de préférence intégré dans l'un des corps (11, 12) ou dans les deux corps (11, 12).

4. Dispositif selon l'une des revendications 2 ou 3, **caractérisé en ce que** le chauffage (23) est conçu pour produire une température de 100° Celsius à 400° Celsius au niveau du substrat (10).

5. Dispositif selon l'une des revendications précédentes, **caractérisé en ce que** la distance (d) est comprise dans la plage allant de 8 mm à 15 mm.

6. Dispositif selon l'une des revendications précédentes, **caractérisé en ce que** le diamètre du substrat est supérieur à 150 mm, de préférence compris entre 150 mm et 300 mm.

**7.** Dispositif selon la revendication 6, **caractérisé en ce que** le substrat (10) est en forme de disque, de préférence un disque de stockage, en particulier une galette semiconductrice.

**8.** Dispositif selon l'une des revendications précédentes, **caractérisé en ce que** les corps plats (11, 12) sont agencés essentiellement horizontaux et **en ce que** le substrat (10) est de préférence posé sur le corps en forme de plaque inférieur (11).

**9.** Dispositif selon l'une des revendications précédentes, **caractérisé en ce que** les corps plats (11, 12) sont agencés essentiellement horizontaux et **en ce que** le substrat (10) est posé de préférence sur au moins trois broches (28), lesquelles sont montées sur le corps en forme de plaque inférieur (11) et définissent une distance en forme de fente.

**10.** Dispositif selon l'une des revendications précédentes, **caractérisé en ce qu'**il est prévu de chaque côté du substrat (10) une arrivée de gaz (13) avec un flux de gaz radial laminaire.

**11.** Dispositif selon l'une des revendications précédentes, **caractérisé en ce que** l'arrivée de gaz (13) est agencée de façon essentiellement centrée par rapport à au moins l'un des corps (11, 12) et aboutissant dans l'interstice (28).

**12.** Dispositif selon l'une des revendications précédentes, **caractérisé en ce que** les ouvertures (18) sont réalisées sur le corps supérieur (12).

**13.** Dispositif selon la revendication 12, **caractérisé en ce que** les ouvertures (18) présentent différents diamètres d'ouverture sur le côté orienté vers l'interstice (28).

**14.** Dispositif selon l'une des revendications précédentes, **caractérisé en ce que** l'arrivée de gaz (13) est conçue pour effectuer, dans un temps de traitement de 30 s, de 5 à 15 changements de gaz.

**15.** Procédé pour dégazer un substrat en forme de plaque (10) dans un environnement évacué avec deux corps (11, 12) parallèles essentiellement plats, lesquels présentent une distance (d) qui est inférieure à leur extension longitudinale (1) formant un interstice (28), dans lequel un substrat plat (10) est agencé entre les corps (11, 12), une arrivée de gaz (13) étant agencée dans au moins l'un des corps (11, 12) pour produire un flux de gaz dans l'interstice (28) le long des corps (11, 12) et du substrat (10) dans le sens radial par rapport à la périphérie des corps (11, 12), le flux de gaz y étant pompé par le biais d'une ouverture de pompe (14), l'arrivée de gaz étant conçue sur au moins un des corps (11, 12) avec plusieurs ouvertures (18) pour créer un courant de gaz, et les ouvertures (18) étant agencées réparties sur la surface du au moins un corps (11, 12), **caractérisé en ce que** le flux de gaz est un flux de gaz laminaire dans la mesure où:

  - les ouvertures (18) de très petit diamètre débouchent respectivement dans une zone avec un diamètre essentiellement élargi (20), laquelle zone forme la sortie de la buse qui débouche dans la zone du courant de gaz laminaire;
  - la distance (d) est dans la plage allant de 5 mm à 30 mm;
  - le flux de gaz laminaire est dans la plage allant de 300 sccm à 1000 sccm;
  - la pression de service est dans la plage allant de 10 à 50 mbar.

**16.** Procédé selon la revendication 15, **caractérisé en ce que** le substrat (10) est chauffé avec un chauffage (23).

**17.** Procédé selon la revendication 16, **caractérisé en ce que** le chauffage (23) est réalisé sous la forme d'un élément chauffant électrique, de préférence sous la forme d'un élément chauffant à résistance, cet élément chauffant étant réalisé de préférence intégré dans l'un des corps (11, 12) ou dans les deux corps (11, 12).

**18.** Procédé selon l'une des revendications 15 ou 16, **caractérisé en ce que** le substrat (10) est chauffé à une température de 100° Celsius à 400° Celsius.

**19.** Procédé selon l'une des revendications 15 à 18, **caractérisé en ce que** la distance (d) est comprise dans la plage allant de 8 mm à 15 mm.

**20.** Procédé selon l'une des revendications 15 à 19, **caractérisé en ce que** l'on dégaze un substrat (10) d'un diamètre supérieur à 150 mm, de préférence d'un diamètre compris entre 150 mm et 300 mm.

**21.** Procédé selon l'une des revendications 15 à 20, **caractérisé en ce que** les corps plats (11, 12) sont agencés essentiellement horizontaux et **en ce que** le substrat (10) est monté de préférence sur au moins trois broches (28), lesquelles sont montées sur le corps en forme de plaque inférieur (11) et définissent une distance en forme de fente.

**22.** Procédé selon l'une des revendications 15 à 21, **caractérisé en ce qu'**il est prévu de chaque côté du substrat (10) une arrivée de gaz (13) pour produire un flux de gaz radial laminaire.

**Fig. 1**

**Fig. 2**

**Fig. 3**

**Fig. 4**

Fig. 5

Fig. 6

**Fig. 7**

## Fig. 8

## Fig. 9

## Fig. 10

Fig. 11

Fig. 12

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6263587 B